Europäisches Patentamt

European Patent Office

Office européen des brevets

(19)

(11) Veröffentlichungsnummer: **0 250 934**
**A2**

(12) **EUROPÄISCHE PATENTANMELDUNG**

(21) Anmeldenummer: **87108193.1**

(22) Anmeldetag: **05.06.87**

(51) Int. Cl.4: **G01R 1/073** , G01R 31/28

(30) Priorität: **30.06.86 DE 8617408 U**

(43) Veröffentlichungstag der Anmeldung:
**07.01.88 Patentblatt 88/01**

(84) Benannte Vertragsstaaten:
**AT BE CH DE FR GB IT LI NL** -

(71) Anmelder: **Siemens Aktiengesellschaft Berlin und München**
**Wittelsbacherplatz 2**
**D-8000 München 2(DE)**

(72) Erfinder: **Seinecke, Siegfried, Dr.-Ing.**
**Kiem-Pauli-Weg 3**
**D-8130 Starnberg(DE)**
Erfinder: **Klaster, Viktor, Dipl.-Ing.**
**Stolzingstrasse 4**
**D-8000 München 81(DE)**

(54) **Kontaktiervorrichtung für zu prüfende Bauelemente der Mikroelektronik.**

(57) Die eine Seite eines unter Druck setzbaren Hohlkörpers (8) ist mit einer elastischen Platine (3) luftdicht abgedeckt, die auf ihrer Außenseite elektrische Leiterbahnen (4) für die Kontaktierung des zu prüfenden Bauelements (1) trägt, und gegenüber der elastischen Platine (3) ist ein Druckkörper (11) fest anordenbar, an dem sich beim Unter-Druck-Setzen des Hohlkörpers (8) das zu prüfende Bauelement (1) mit seiner Rückseite abstützt.

FIG 1

EP 0 250 934 A2

## Kontaktiervorrichtung für zu prüfende Bauelemente der Mikroelektronik

Die Erfindung bezieht sich auf eine Kontaktiervorrichtung für zu prüfende Bauelemente der Mikroelektronik, wie z.B. integrierte Schaltungen.

Moderne Bauelemente der Mikroelektronik, wie z.B. integrierte Schaltungen in Leadless Chipcarrier, Flatpackgehäusen oder als Chip auf einer Siliziumscheibe müssen in Prüfeinrichtungen so kontaktiert werden, daß die Kontaktiervorrichtung selbst möglichst nur geringe elektrische Störgrößen (wie z.B. Serieninduktivitäten, Erdkapazitäten und elektromagnetische Kopplungen sowie ohmsche Kontaktwiderstände) erzeugt. Nur dann können die elektrischen Eigenschaften des Bauteils einwandfrei gemessen werden.

Fehlerfreie dynamische Messungen an Subnanosekundenschaltkreisen und -chips sind aber aus folgenden Gründen mit herkömmlichen Kontaktiervorrichtungen schwer durchzuführen: Bauelemente in Flatpack-Gehäusen und Leadless Chipcarrier erhalten zunehmend feinere Kontaktteilungen (unter 1 mm). Eine Kontaktierung durch Einzelfedern hat somit konstruktive Grenzen und erzeugt elektrische Störgrößen.
Eine Kontaktierung durch Verwendung von flexiblen gedruckten Schaltungen in Verbindung mit einem elastischen Andruckkissen führt nicht unbedingt zu gleichmäßigen Kontaktkräften für alle Kontakte.
Bei Chips auf einer Scheibe können nach der bisherigen Methode (Abtastnadeln mit Längen > 1 cm) dynamische Mes sungen nicht durchgeführt werden. Das Padraster auf dem Chip reicht heute bereits herab bis zu 0,1 mm. Eine alternative Kontaktierung mit einer flexiblen gedruckten Schaltung in Verbindung mit einem elastischen Andruckkissen führt auch hierbei nicht mit Sicherheit zu gleichmäßigen Kontaktkräften für alle Kontakte.

Für Leadless Chipcarrier gibt es käufliche Stecksockel. Sie erzeugen jedoch derart große elektrische Störgrößen, daß eine dynamische Messung an Schaltkreisen mit Laufzeiten < 0,4ns stark verfälscht wird. Für Leadless Chipcarrier ist auch bekannt, ringförmig metallisierte Gummizylinder zu verwenden. Diese Kontaktmethode reduziert jedoch die maximale Betriebsfrequenz um etwa 20%. Die Chip-Kontaktierung auf Scheiben erfolgt heute mit Abtastnadeln; es ist damit jedoch keine dynamische Messung möglich.

Der Erfindung lag deshalb die Aufgabe zugrunde, eine Kontaktiervorrichtung zu schaffen, mit der Bauelemente der Mikroelektronik bei der Prüfung kontaktiert werden können, ohne daß dabei nennenswerte elektrische Störgrößen wie Serieninduktivitäten, Erdkapazitäten, elektromagnetische Kopplungen sowie dynamische Kontaktwiderstände auftreten.

Erreicht wird dies durch einen unter Druck setzbaren Hohlkörper, dessen eine Seite mit einer elektrische Leiterbahnen tragenden elastischen Platine luftdicht abgedeckt ist, und durch einen gegenüber der elastischen Platine fest anordenbaren Druckkörper, an dem sich beim unter Druck setzen des Hohlkörpers das zu prüfende Bauelement mit seiner Rückseite abstützt.

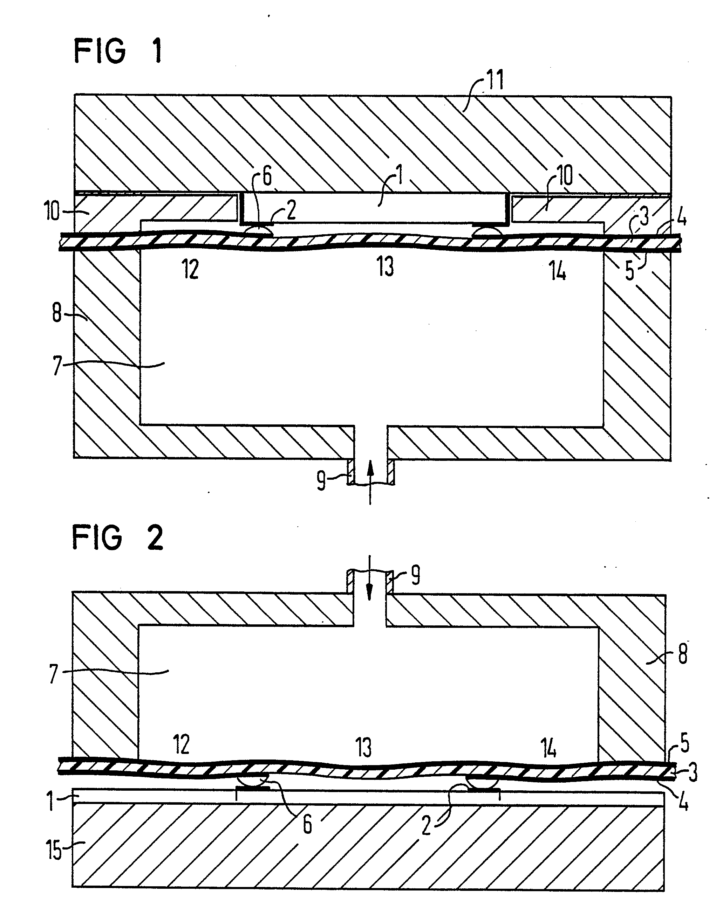

Weitere Einzelheiten der Erfindung ergeben sich aus der nachfolgenden Beschreibung zweier Ausführungsbeispiele anhand der FIG 1 und 2, wobei

FIG 1 ein Ausführungsbeispiel der erfindungsgemäßen Vorrichtung zeigt, mit der separate mikroelektronische Bauelement, wie z.B. integrierte Schaltungen, für die Prüfung kontaktiert werden können, und

FIG 2 ein Ausführungsbeispiel der erfindungsgemäßen Vorrichtung zeigt, mit der mikroelektronische Bauelemente kontaktiert werden können, die sich noch auf einem sogenannten Wafer befinden.

Gleiche Teile tragen in den beiden Figuren gleiche Bezugszeichen.

Wie aus den Figuren ersichtlich, besteht die erfindungsgemäße Vorrichtung in erster Linie aus einem Hohlkörper 8, dessen eine Seite mit einer elektrische Leiterbahnen 4, 5 tragenden elastischen Platine 3 luftdicht abgedeckt ist. Der Hohlkörper 8 besitzt außerdem eine Einrichtung 9 zum Anschließen einer Druckquelle, die der Übersichtlichkeit halber hier weggelassen und lediglich durch einen Pfeil angedeutet worden ist. Die Vorrichtung umfaßt außerdem einen gegenüber der Platine 3 fest anordenbaren Druckkörper 11 bzw. 15, an dem sich beim Kontaktieren das zu prüfende Bauelement 1 mit seiner Rückseite abstützt.

Falls es sich bei dem zu kontaktierenden Bauelement schon um ein fertig konfektioniertes Bauelement wie z.B. einen integrierten Schaltkreis im Leadless Chipcarrier handelt, ist es wie FIG 1 zeigt vorteilhaft, eine Einrichtung zum Positionieren des prüfenden Bauelementes in einer bestimmten Lage gegenüber den Leiterbahnen 4, 5 der Platine 3 vorzusehen. In dem Ausführungsbeispiel von FIG 1 dient dazu ein Rahmen 10, in den das zu prüfende Bauelement 1 eingelegt wird.

Die den Hohlkörper 8 auf der einen Seite luftdicht abdeckende elastische Platine 3, trägt auf ihrer Außenseite, d.h. der dem zu kontaktierenden Bauelement zugewandten Seite gedruckte Leiterbahnen 4 und auf der dem Innenraum 7 des Hohlkörpers 8 zugewandten Seite eine Erdungsebene 5. Diese kann im Bereich des Innenraumes 7 des Hohlkörpers 8 auch als Gitter ausgebildet sein.

Wenn die Metallisierungen der Kontaktflecken 2 des zu kontaktierenden Bauelementes nicht weit genug über den Träger (z.B. aus Keramik) hinausragen, kann es zweckmäßig sein, an den inneren Enden der Leiterbahnen 4 metallische Höcker 6 zum Kontaktieren der Leiterbahnen 4 mit den zugeordneten Kontaktflecken 2 des zu prüfenden Bauelementes 1 vorzusehen.

Die Kontaktierung des Bauelementes 1 geschieht folgendermaßen: Die mit elektrischen Leiterbahnen versehene elastische Platine 3 ist zwischen den Führungsrahmen 10 und den Hohlkörper 8 luftdicht eingespannt und der Innenraum 7 des Hohlkörpers 8 befindet sich zunächst noch unter normalem Luftdruck. Das zu prüfenden Bauelement 1 wird in der Ausnehmung, die in den Rahmen 10 vorgesehen ist, auf die Platine 3 gelegt und liegt zunächst nur lose auf ihr auf. Dann wird das Druckstück 11 aufgelegt und mit dem Rahmen 10 durch hier nicht im einzelnen dargestellte Mittel, wie Schrauben, Klammern, Riegel oder ähnliches verspannt und dadurch verhindert, daß das zu prüfende Bauelement nach oben ausweicht. Der Innenraum 7 des Hohlkörpers 8 wird dann durch Zuführen von Druckluft über die Anschlußeinrichtung 9 unter Überdruck gesetzt. Dadurch werden alle metallischen Höcker 6 an die zuge ordneten Kontaktflecken 2 des zu prüfenden Bauelementes 1 gepreßt. Die Platine 3 biegt sich dabei in den Zonen 12, 13 und 14 und auch zwischen den Kontakten elastisch nach oben durch und bewirkt einen gleichmäßigen Andruck aller Enden 6 der Leiterbahnen 4 an die Kontaktflecken 2 des zu prüfenden Bauelementes 1. Der Überdruck im Innenraum 7 des Hohlkörpers 8 hängt dabei von der Elastizität der Platine, der Anzahl und dem Raster der metallischen Höcker 6 und dem gewünschten maximalen Kontaktwiderstand ab.

Eine Kontaktiervorrichtung dieser Art ermöglicht eine gleichmäßige Kontaktgabe aller Anschlüsse des zu kontaktierenden Bauelementes, erzeugt bei sehr geringer Höhe der metallischen Höcker 6 praktisch keine elektrischen Störgrößen und erlaubt die Ausbildung der Prüfleitungen für das zu prüfende Bauelement als Wellenleitung bis zu den Anschlußflecken des Bauelementes.

FIG 2 zeigt die Anwendung der erfindungsgemäßenKontaktiervorrichtung für zu prüfende Bauelemente der Mikroelektronik, die sich noch als nicht abgetrennte Systeme auf einer Scheibe 1 befinden. Da jedes einzelne zu prüfende und zu kontaktierende Bauelement noch nicht von der Scheibe 1 abgetrennt ist, ist es nicht erforderlich, einen Rahmen zum Positionieren des zu prüfenden Bauelementes, wie z.B. bei dem Ausführungsbeispiel nach FIG 1, vorzusehen. Ferner dient als Druckkörper der Träger 15, auf dem die Scheibe 1 liegt. Die Kontaktierung erfolgt dabei folgendermaßen: Der Innenraum 7 des Hohlkörpers 8 befindet sich zunächst unter normalem Druck und die elastische Platine 3 ist mit dem Hohlkörper 8 luftdicht verbunden. Hohlkörper 8 und elastische Platine 3 werden mit den auf ihr vorgesehenen Leiterbahnen 4 in einem geringen Abstand über der Scheibe 1 positioniert. Dann wird die Trägerplatte 15 mit der Scheibe 1 nach oben bewegt. Der Innenraum 7 des Hohlkörpers 8 wird dann über eine mit Hilfe der Einrichtung 9 anzuschließende Druckquelle unter Druck gesetzt. Dadurch werden alle metallischen Höcker 6 an die Kontaktflecken 2 des noch in der Scheibe 1 befindlichen Bauelementes angedrückt. Bei entsprechender Elastizität der elastischen Platine 3 und entsprechender Ausgestaltung der metallischen Höcker 6 werden alle Kontaktflecken 2 des zu kontaktierenden Bauelementes in der Scheibe 1 gleichmäßig kontaktiert.

Auch dieses Ausführungsbeispiel der erfindungsgemäßen Anordnung ist auf eine beliebige Anzahl von Kontaktflecken des Bauelementes und ein beliebig feines Raster derselben anwendbar, und auch hier ist eine vollwertige dynamische Messung der Bauelemente durch Ausbildung der elektrischen Leiterbahnen als Streifenleiter möglich.

Bezugszeichenliste

1 = Bauelement
2 = Kontaktflecken
3 = Platine
4 = Leiterbahnen
5 = Leiterbahnen
6 = metallischer Höcker
7 = Innenraum
8 = Hohlkörper
9 = Einrichtung
10 = Rahmen
11 = Druckkörper
12 = Zone
13 = Zone
14 = Zone
15 = Trägerplatte

**Ansprüche**

1. Kontaktiervorrichtung für zu prüfende Bauelemente der Mikroelektronik, wie z.B. integrierte Schaltungen,
**gekennzeichnet durch** einen unter Druck setzbaren Hohlkörper (8), dessen eine Seite mit einer elektrische Leiterbahnen (4,5) tragenden elastischen Platine (3) luftdicht abgedeckt ist, und durch einen gegenüber der Platine (3) fest anordenbaren Druckkörper (11,15), an dem sich beim Unter-Druck-setzen des Hohlkörpers (8) das zu prüfende Bauelement (1) mit seiner Rückseite abstützt.

2. Kontaktiervorrichtung nach Anspruch 1, **dadurch gekennzeichnet,** daß an dem Hohlkörper (8) eine Einrichtung (9) zum Anschließen einer Druckquelle angeordnet ist.

3. Kontaktiervorrichtung nach Anspruch 1 oder 2, **gekennzeichnet durch** eine Einrichtung (10) zum Positionieren des zu prüfenden Bauelements (1) in einer bestimmten Lage gegenüber den Leiterbahnen (4,5) der Platine (3).

4. Kontaktiervorrichtung nach Anspruch 3, **dadurch gekennzeichnet,** daß die Einrichtung zum Positionieren des zu prüfenden Bauelements aus einem Rahmen (10) besteht.

5. Kontaktiervorrichtung nach Anspruch 4, **dadurch gekennzeichnet,** daß der Druckkörper (11) mit dem Rahmen (10) und/oder Hohlkörper (8) fest verbindbar ist.

6. Kontaktiervorrichtung nach einem der Ansprüche 1 bis 5, **dadurch gekennzeichnet,** daß die elastische Platine (3) auf ihrer Außenseite sog. gedruckte Leiterbahnen (4) und auf der Innenseite eine Erdungsebene (5) trägt.

7. Kontaktiervorrichtung nach Anspruch 6, **dadurch gekennzeichnet,** daß die Erdungsebene (5) zumindest im Bereich des Innenraumes (7) des Hohlkörpers (8) als Gitter ausgebildet ist.

8. Kontaktiervorrichtung nach Anspruch 6, **dadurch gekennzeichnet,** daß an den inneren Enden der Leiterbahnen (4) metallische Höcker (6) zum Kontaktieren der Leiterbahnen (4) mit den zugeordneten Kontaktflecken (2) des zu prüfenden Bauelements (1) angeordnet sind.

## FIG 1

## FIG 2